# EUROPEAN PATENT SPECIFICATION

(11) **EP 1 890 345 B1**
(45) Date of publication and mention of the grant of the patent: **13.04.2011**
(21) Application number: 07252172.7
(22) Date of filing: 25.05.2007
(51) Int. Cl.: H01L 41/24

(54) **Method for manufacturing piezoelectric/electrostrictive element**
Verfahren zur Herstellung eines piezoelektrischen/elektrostriktiven Elements
Procédé pour fabriquer un élément piézoélectrique/électrostrictif

(30) Priority: 14.08.2006 JP 2006221129; 14.03.2007 JP 2007065922
(43) Date of publication of application: 20.02.2008
(73) Proprietor: NGK Insulators, Ltd., Nagoya-city, Aichi 467-8530 (JP)
(72) Inventor: Ohnishi, Takao, NGK Insulators Ltd.,, Nagoya City, Aichi-ken 467-8530 (JP); Tani, Makoto, NGK Insulators Ltd.,, Nagoya City, Aichi-ken 467-8530 (JP); Wada, Takashi, NGK Insulators Ltd.,, Nagoya City, Aichi-ken 467-8530 (JP); Koizumi, Takaaki, NGK Insulators Ltd.,, Nagoya City, Aichi-ken 467-8530 (JP)
(74) Representative: Naylor, Matthew John

(56) References cited:
- EP-A- 1 453 114
- EP-A- 1 527 879
- US-A1- 2003 199 105
- US-A1- 2006 119 229

## Description

### BACKGROUND OF THE INVENTION

### 1. Field of the Invention

The present invention relates to a method for manufacturing a piezoelectric/electrostrictive element including a piezoelectric/electrostrictive body made of a piezoelectric/electrostrictive material containing an alkali metal or an alkaline-earth metal.

### 2. Description of the Related Art

A piezoelectric/electrostrictive device is used as an actuator or a sensor by virtue of mechano-electrical conversion of a piezoelectric/electrostrictive element including a pair of electrodes and a piezoelectric/electrostrictive body sandwiched therebetween. The mechano-electrical conversion of the piezoelectric/electrostrictive element occurs according to the distortion that is induced by an electric field generated by the piezoelectric effect (inverse piezoelectric effect) or electrostrictive effect of the piezoelectric/electrostrictive material (piezoelectric material, electrostrictive material, etc.) of the piezoelectric/electrostrictive body.

Lead zirconate titanate (PZT) has been used as the principal piezoelectric/electrostrictive material of piezoelectric/electrostrictive devices for a long time because PZT advantageously has a large residual polarization. However, alternatives to PZT are desired due to global regulation on lead, and bismuth-based perovskite is increasingly used, which has a residual polarization as large as that of PZT and is suitable for generation of displacement and vibration.

Although it seems that there is not known document having the same object as the below-described object of the invention, JP-A-2004-282053 and JP-A-2001-260356 have disclosed washing processes associated with piezoelectric/electrostrictive elements.

[Document 1] JP-A-2004-282053
[Document 2] JP-A-2001-260356
[Document 3] JP-A-8-201265

However, if bismuth-based perovskite containing an alkali metal or an alkaline-earth metal (for example, (Bi_{0.5}Na_{0.5}) TiO₃ or a material containing as a major component the afore-mentioned one) is used as the material of the piezoelectric/electrostrictive body, the initial electrical characteristics can be varied among the resulting piezoelectric/electrostrictive devices or the changes in electrical characteristics can occur with elapse of time. Thus, the electrical characteristics have larger variations than those in use of PZT. This is undesirable in the use of a piezoelectric/electrostrictive device as a sensor detecting an electrical characteristic of vibration (see, for example, JP-A-8-201265). It is also undesirable in the use as an actuator, which requires uniform displacement.

### SUMMARY OF THE INVENTION

Accordingly, an object of the invention is to provide a piezoelectric/electrostrictive device that includes a piezoelectric/electrostrictive body made of a piezoelectric/electrostrictive material containing an alkali metal or an alkaline-earth metal and that exhibits stable electrical characteristics.

The present inventors have found that the electric characteristics of piezoelectric/electrostrictive devices are liable to vary under high humid conditions as a result of the intensive studies. We have reached the finding therefrom that the major causes of the variance in the electric characteristics are presumed, with some uncertainty, to be in the point that alkali metals and/or alkaline earth metals which are contained in the piezoelectric/eletrostrictive body are present or adhered remaining thereon in an active state at the time of firing the piezoelectric/electrostrictive body or electrodes, or subjecting them to heat treatment during the manufacturing process of the piezoelectric/electrostrictive device. More specifically, the alkali metal or alkaline-earth metal in the piezoelectric/electrostrictive body is dissolved in water from the air deposited on the surface of the piezoelectric/electrostrictive device in a random fashion and irregularly reduces the insulation resistance between the pair of electrodes with the piezoelectric/electrostrictive body sandwiched therebetween. Probably, the electrical characteristics of the piezoelectric/electrostrictive device (in a strict sense, piezoelectric/electrostrictive element) are thus varied. Successive studies have found that the above object can be accomplished by preventing the reduction in insulation resistance by the following measures.

Accordingly, the present invention is directed to a method for manufacturing a piezoelectric/electrostrictive element as set out in claim 1.

In the method, the piezoelectric/electrostrictive element having multilayer structure including the piezoelectric/electrostrictive body and the pair of film electrodes with the piezoelectric/electrostrictive body sandwiched therebetween can be prepared by a known process.

Preferably, the method further includes step C1 of heating the piezoelectric/electrostrictive element after the step A1 and before the step B1. In this instance, the heating in the step C1 is preferably performed at a temperature of from 60 to 900°C.

Preferably, step B1 includes the sub steps of bringing the acidic solution or pure water into contact with the surface of the piezoelectric/electrostrictive body, drying the piezoelectric/electrostrictive body, and performing air blowing onto the piezoelectric/electrostrictive body. More specifically, an acidic solution or pure water is brought into contact with the surface of the piezoelectric/electrostrictive body, followed by drying to remove the liquid and, further, air blowing.

Preferably, the acidic solution or pure water is used in form of mist, according to the method of the present invention.

Preferably, in the method of the present invention, the washing at the step B1 removes a compound containing the alkali metal or alkaline-earth metal from the surface of the piezoelectric/electrostrictive element. In other words, the method of the present invention is suitable to remove a compound containing the alkali metal or alkaline-earth metal from the surface of the piezoelectric/electrostrictive element. The method of the present invention is particularly suitable when the compound is at least one selected from a hydroxide, a carbonate, a hydrogencarbonate, a sulfate, or a sulfide.

Preferably, in the method of the present invention, the washing at the step B1 removes at least one selected from a sodium salt, a sulfate or a sulfide containing constituent of the film electrodes and adhered on the surface of the piezoelectric/electrostrictive element therefrom. In other words, the method is suitable to remove at least one selected from a sodium salt, a sulfate or a sulfide containing constituent of the film electrodes and adhered on the surface of the piezoelectric/electrostrictive element therefrom.

The present invention is also directed to a method for manufacturing a piezoelectric/electrostrictive device as set out in claim 9 dependent on claim 1. The method for manufacturing the piezoelectric/electrostrictive device includes step A2 of firing the piezoelectric/electrostrictive body and the electrode films, and step B2 of washing the piezoelectric/electrostrictive device including the piezoelectric/electrostrictive body with an acidic solution or pure water. The Step B2 is performed at least once after the step A2.

In this method, the ceramic substrate having a thin diaphragm portion and a thick portion integrally formed around the thin diaphragm portion, the thin diaphragm portion and the thick portion defining a cavity communicating with the outside of the structure can be prepared by known processes. And the piezoelectric/electrostrictive element having multilayer structure including a piezoelectric/electrostrictive body containing (1-x) (Bi_{0.5} Na_{0.5}) TiO₃-xKNbO₃, wherein 0 ≤ x ≤ 0.06 in terms of molar fraction, as a major component and a pair of film electrodes with the piezoelectric/electrostrictive body sandwiched therebetween can be also prepared by known processes.

Preferably, step B2 removes a compound containing (1-x) (Bi_{0.5} Na_{0.5}) TiO₃-xKNbO₃, wherein 0 ≤ x ≤ 0.06 in terms of molar fraction, as a major component from the surface of the structure defining the piezoelectric/electrostrictive device. In other words, the method for manufacturing the piezoelectric/electrostrictive device is suitable to remove a compound containing (1-x) (Bi_{0.5} Na_{0.5}) TiO₃-xKNbO₃, wherein 0 ≤ x ≤ 0.06 in terms of molar fraction, as a major component from the surface of the structure of the piezoelectric/electrostrictive device. The method of the present invention is particularly suitable when the compound is at least one selected from a hydroxide, a carbonate, a hydrogencarbonate, a sulfate, or a sulfide.

Preferably, the washing at the step B2 removes a sodium salt, a sulfate or a sulfide containing constituent of the film electrodes and adhered on the surface of the piezoelectric/electrostrictive device therefrom. In other words, the method for manufacturing the piezoelectric/electrostrictive device is suitable to remove a sodium salt, a sulfate or a sulfide containing constituent of the film electrodes and adhered on the surface of the piezoelectric/electrostrictive device therefrom.

The method for manufacturing the piezoelectric/electrostrictive device is the same as the method for manufacturing the piezoelectric/electrostrictive element, except that the object to be manufactured includes a ceramic substrate. Since the step of washing is preferably performed just before shipping, the object to be washed in step B2 differs from the object to be washed at step B1 of the method for manufacturing the piezoelectric/electrostrictive element, according to the intended product. If the piezoelectric/electrostrictive element is independently prepared and then fixed to the ceramic substrate with, for example, an adhesive to produce the piezoelectric/electrostrictive device, it should be understood that both the methods for manufacturing the piezoelectric/electrostrictive element and the piezoelectric/electrostrictive device are applied.

The acidic solution used in the methods of the present invention can be dilute sulfuric acid or dilute hydrochloric acid. The pure water preferably has a specific resistance of 0.5 to 18 MΩ·cm (at 25°C). Pure water is preferable to the acidic solution because the use of pure water allows the material of the electrodes to be selected from a wide range and does not corrode the electrodes.

The methods of the present invention is intended to manufacture a piezoelectric/electrostrictive element and a piezoelectric/electrostrictive device expressed by the words "piezoelectric/electrostrictive", and the displacement produced in the piezoelectric/electrostrictive material is the total of the displacements according to distortions induced by electric fields. More specifically, the piezoelectric/electrostrictive element and piezoelectric/electrostrictive device used herein, for example, for electromechanical conversion (as an actuator), are not limited in a narrow sense to a type using the inverse piezoelectric effect of generating a distortion substantially proportional to an applied electric field, and a type using the electrostrictive effect of generating a distortion substantially proportional to square of an applied electric field, and cover various types using, for example, polarization reversal occurring in general ferroelectric materials, and antiferroelectric phase-ferroelectric phase transition occurring in an antiferroelectric material.

The method for manufacturing the piezoelectric/electrostrictive element comprising step A1 of firing the piezoelectric/electrostrictive body and the electrode films and step B1 of washing the piezoelectric/electrostrictive element including the piezoelectric/electrostrictive body with an acidic solution or pure water, wherein the step B1 is performed at least once after the step A1. Consequently, in case of manufactured piezoelectric/electrostrictive element, an alkali metal or alkaline-earth metal thereof present in an active state or adhered remaining on the surface of the piezoelectric/electrostrictive body after firing, or a compound formed by, for example, sulfuration is reliably removed from the resulting piezoelectric/electrostrictive element. Hence, in a piezoelectric/electrostrictive element produced by the method of the present invention, the insulation resistance between the pair of electrodes with the piezoelectric/electrostrictive body sandwiched therebetween is not irregularly reduced by an alkali metal or alkaline-earth metal or the compound containing them even if the piezoelectric/electrostrictive body contains the alkali metal or alkaline-earth metal. Therefore, the resulting piezoelectric/electrostrictive element exhibits stable electrical characteristics without variation. Since the alkali metal or alkaline-earth metal or the compounds containing afore-mentioned one has been removed, the insulation of the surface of the piezoelectric/electrostrictive body is kept high even in high-humidity environments. Thus, the method of the present invention can achieve a more reliable piezoelectric/electrostrictive element than other methods.

The method for manufacturing the piezoelectric/electrostrictive element comprising step A1 of firing the piezoelectric/electrostrictive body and the electrode films and step B1 of washing the piezoelectric/electrostrictive element including the piezoelectric/electrostrictive body with an acidic solution or pure water, wherein the step B1 is performed at least once after the step A1. Consequently, in case of manufactured piezoelectric/electrostrictive element, a constituent of the electrodes thereof present in an active state or adhered remaining on the surface of the piezoelectric/electrostrictive body after firing, or the compound containing them formed by, for example, sulfuration or sulfatization is reliably removed from the resulting piezoelectric/electrostrictive element. Hence, in a piezoelectric/electrostrictive element produced by the method of the present invention, the insulation resistance between the pair of electrodes with the piezoelectric/electrostrictive body sandwiched therebetween is not irregularly reduced by the constituents of the electrodes or the compounds containing them. Therefore, the resulting piezoelectric/electrostrictive element exhibits stable electrical characteristics without variation. In addition, since the constituent or the compound has been removed, the insulation of the surface of the piezoelectric/electrostrictive body is kept high even in high-humidity environments. Thus, the method of the present invention can achieve a more reliable piezoelectric/electrostrictive element than other methods.

In a preferred embodiment of the present invention, step C1 of heating the piezoelectric/electrostrictive element may be performed after the step A1 and before the step B1, so that the excess of the alkali metal or alkaline-earth metal in the piezoelectric/electrostrictive body, or the compounds containing them can be completely removed. The resulting piezoelectric/electrostrictive element therefore exhibits stable electrical characteristics without variation. In order to increase the productivity, a plurality of piezoelectric/electrostrictive elements may be formed on a substrate and then the substrate is cut into elements with a dicer. In this instance, the cut elements may be washed with grinding fluid simultaneously with cutting.

In a preferred embodiment of the present invention, step B1 may include the sub steps of bringing the acidic solution or pure water into contact with the surface of the piezoelectric/electrostrictive body, drying the piezoelectric/electrostrictive body, and performing air blowing onto the piezoelectric/electrostrictive body. In a more preferred embodiment, the acidic solution or pure water may be used in form of mist. This reduced the amount of the acidic solution or pure water to be used and the amount of waste solution or water, and is thus environmentally friendly.

The method for manufacturing the piezoelectric/electrostrictive device produces the same effect as the method for manufacturing the piezoelectric/electrostrictive element. More specifically, it includes step A2 of firing the piezoelectric/electrostrictive body and the electrode films and step B2 of washing the structure including the piezoelectric/electrostrictive body with an acidic solution or pure water, wherein the step B2 is performed at least once after the step A2. Consequently, in case of manufactured piezoelectric/electrostrictive element, the alkali metal or alkaline-earth metal thereof present in an active state or adhered remaining on the surface of the piezoelectric/electrostrictive body after firing, or the compounds containing them is reliably removed from the resulting piezoelectric/electrostrictive element. Therefore, the resulting piezoelectric/electrostrictive device exhibits stable electrical characteristics without variation. In addition, the insulation of the surface of the piezoelectric/electrostrictive body of the piezoelectric/electrostrictive device is kept high even in high-humidity environments. Thus, the method of the present invention can achieve a more reliable piezoelectric/electrostrictive device than other methods.

### BRIEF DESCRIPTION OF THE DRAWINGS

Fig. 1 is a plan view of a piezoelectric/electrostrictive device;
Fig. 2 is a sectional view of the piezoelectric/electrostrictive device shown in Fig. 1, taken along line A-A;
Fig. 3 is a sectional view of the piezoelectric/electrostrictive device shown in Fig. 1, taken along line B-B;
Fig. 4 is a flow chart of a method for manufacturing a piezoelectric/electrostrictive device according to an embodiment of the present invention;
Fig. 5 is a flow chart of a method for manufacturing a piezoelectric/electrostrictive element according to an embodiment of the present invention;
Fig. 6 is a plot showing the changes in insulation resistance of piezoelectric/electrostrictive devices with time under conditions of high humidity;
Fig. 7 is an X-ray microanalyser (electron probe microanalyser, EPMA) photograph of the surface of a piezoelectric/electrostrictive device prepared in Example 1 before washing; and
Fig. 8 is an X-ray microanalyser (EPMA) photograph of the surface of the piezoelectric/electrostrictive device prepared in Example 1 after washing.

### EXPLANATION OF SYMBOLS

1 ceramic substrate
2 a thick portion
3 a thin diaphragm portion
4 lower electrode
5 piezoelectric/electrostrictive body
6 upper electrode
7A, 7B an incompletely joined region
8 an auxiliary electrode
9 through-holes
10 a cavity
11 an overhang (of piezoelectric/electrostrictive body)
12 piezoelectric/electrostrictive element
20 piezoelectric/electrostrictive device

### DESCRIPTION OF THE PREFERRED EMBODIMENTS

The following embodiment is a preferred one.

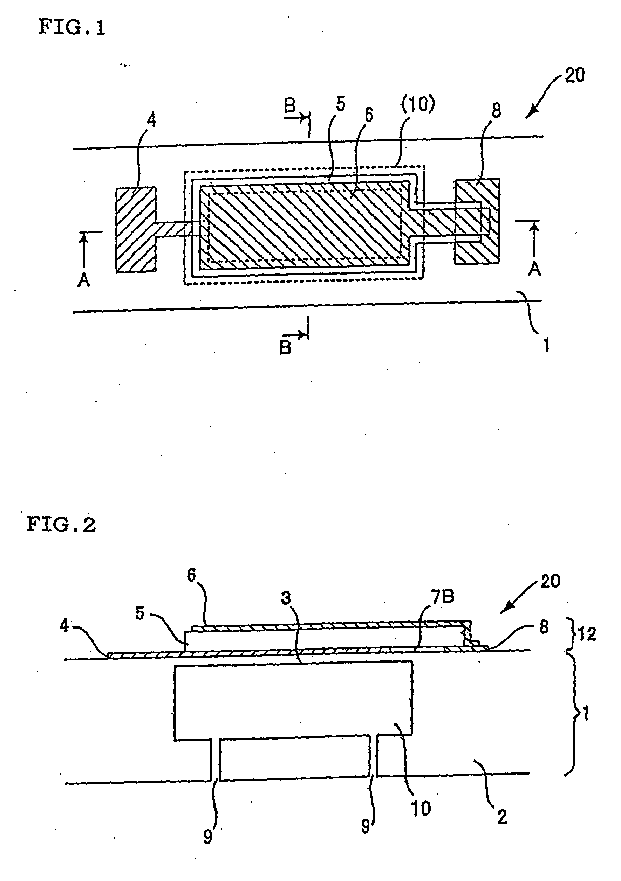

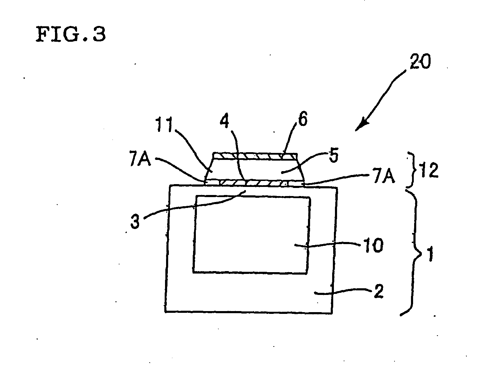

First, the piezoelectric/electrostrictive device manufactured by the method for manufacturing a piezoelectric/electrostrictive device of the present invention will be described with reference to an embodiment. The piezoelectric/electrostrictive device includes a piezoelectric/electrostrictive element manufactured by the method for manufacturing a piezoelectric/electrostrictive element according of the present invention. Fig. 1 is a plan view (top view) of a piezoelectric/electrostrictive device according to an embodiment of the present invention, Fig. 2 is a sectional view of the piezoelectric/electrostrictive device shown in Fig. 1 taken along line A-A, and Fig. 3 is a sectional view of the piezoelectric/electrostrictive device shown in Fig. 1 taken along line B-B.

The piezoelectric/electrostrictive device 20 shown in Figs. 1 to 3 includes a ceramic substrate 1 and a piezoelectric/electrostrictive element 12. The ceramic substrate 1 has a thin diaphragm portion 3 and a thick portion 2 integrally formed around the thin diaphragm portion 3. The thin diaphragm portion 3 and the thick portion 2 define a cavity 10 communicating with the outside of the ceramic substrate 1 through through-holes 9. The piezoelectric/electrostrictive element 12 is disposed on the external surface of the thin diaphragm portion 3 of the ceramic substrate 1. The piezoelectric/electrostrictive element 12 has multilayer structure including a piezoelectric/electrostrictive body 5 and a pair of film electrodes (upper electrode 6 and lower electrode 4) with the piezoelectric/electrostrictive body 5 sandwiched therebetween.

The piezoelectric/electrostrictive device 20 may have an auxiliary electrode 8, and the lower electrode 4 has such a length as the end at the auxiliary electrode side of the lower electrode 4 does not extend beyond the thin diaphragm portion 3. The auxiliary electrode 8 is independent of the lower electrode 4 and is disposed so as to lie under the piezoelectric/electrostrictive body 5 in such a manner that an incompletely joined region 7B where piezoelectric/electrostrictive body 5 is incompletely joined with the ceramic substrate 1 is formed between the lower electrode 4 and the auxiliary electrode 8. The ends of the lower electrode 4 and auxiliary electrode 8 on the thick portion 2 are used as lead terminals. Alternatively, a joining layer for joining the piezoelectric/electrostrictive body 5 and the thin diaphragm portion 3 may be formed at the position where the incompletely joined region 7B is to be formed (position between the lower electrode 4 and the auxiliary electrode 8). The piezoelectric/electrostrictive body 5 extends across the region between the electrode 4 and the auxiliary electrode 8 and has an area capable of covering the lower electrode 4. The upper electrode 6 is formed on the piezoelectric/electrostrictive body 5 and extends to the auxiliary electrode 8 so as to be electrically connected to the auxiliary electrode 8.

An overhang 11 is formed in the piezoelectric/electrostrictive body 5 (see Fig. 3). The overhang 11 is defined by the incompletely joined region 7A where the piezoelectric/electrostrictive body 5 is incompletely joined with the ceramic substrate 1. Since the overhang 11 is not completely joined with the ceramic substrate 1, a sufficient amount of bending displacement, force generation, and vibration can be produced. In the case that it is required to make variations and changes with elapse of time in electrical constant smaller as a sensor, one may make the size of the lower electrode 4 the same to that of the piezoelectric/electrostrictive body 5, without forming overhang 11

"Incompletely joined " means the state where the piezoelectric/electrostrictive body 5 is partially joined or not joined with the ceramic substrate 1. More specifically, the peel strength between the piezoelectric/electrostrictive body 5 and the ceramic substrate 1 is 0.5 kg/mm² or less in the incompletely joined state.

In the piezoelectric/electrostrictive device 20, when the piezoelectric/electrostrictive element 12 is driven (generates displacement), the thin diaphragm portion 3 of the ceramic substrate 1 vibrates in synchronization with the displacement. The thickness of the thin diaphragm portion 3 is set so as not to suppress the vibration of the piezoelectric/electrostrictive body 5, and is typically 50 µm or less, preferably 30 µm or less, and more preferably 15 µm or less. The thin diaphragm portion 3 may have any shape in plan view and, for example, may be rectangular, square, triangular, elliptical, or circular. If the piezoelectric/electrostrictive device 20 is used in an application in which the resonant mode needs to be simplified, the thin diaphragm portion 3 has a rectangular or circular shape as required.

The materials of the components of the piezoelectric/electrostrictive device 20 will now be described.

The ceramic substrate 1 is preferably made of a heat-resistant, chemically stable, insulating material. This is because heat treatment is required when the lower electrode 4, the piezoelectric/electrostrictive body 5, and the upper electrode 6 are integrated to form the piezoelectric/electrostrictive element 12, and because the piezoelectric/electrostrictive device 20 may be used in an electrically conductive or corrosive liquid to sense a characteristic of the liquid. Preferred materials for the ceramic substrate 1 include stabilized zirconium oxide, aluminium oxide, magnesium oxide, mullite, aluminium nitride, silicon nitride, and glass. Among these most preferred is stabilized zirconium oxide. Stabilized zirconium oxide ensures high mechanical strength even if the thin diaphragm portion has a small thickness, and is superior in toughness.

The piezoelectric/electrostrictive body 5 is made of (Bi_{0.5}Na_{0.5})TiO₃, (1-x) (Bi_{0.5}Na_{0.5})TiO₃-xKNbO₃ (x satisfies 0 ≤ x ≤ 0.06 in terms of molar fraction), and materials containing as a major component the afore-mentioned one.

If the joining layer is provided, it can be made of an organic or inorganic material that can adhere to or join both the piezoelectric/electrostrictive body 5 and the ceramic substrate 1. Preferably, the material of the joining layer has an intermediate thermal expansion coefficient between the thermal expansion coefficients of the materials of the ceramic substrate 1 and the piezoelectric/electrostrictive body 5, from the viewpoint of ensuring high adhesion. If the piezoelectric/electrostrictive body 5 is fired (heated), a glass material having a softening point higher than the temperature at which the piezoelectric/electrostrictive body 5 is fired is suitable. Such a material can tightly join the piezoelectric/electrostrictive body 5 and the ceramic substrate 1, and can prevent deformation resulting from heat treatment because of its high softening point. If the piezoelectric/electrostrictive body 5 is made of any of the materials listed above, the joining layer is preferably made of a material mainly containing (1-x) (Bi_{0.5}Na_{0.5})TiO₃-xKNbO₃ (x satisfies 0.08 ≤ x ≤ 0.5 in terms of molar fraction). Such a material has high adhesion to both the piezoelectric/electrostrictive body 5 and the ceramic substrate 1, and can reduce negative effects of heat treatment on the piezoelectric/electrostrictive body 5 and the ceramic substrate 1. More specifically, this material has a similar composition to the piezoelectric/electrostrictive body 5 and accordingly has a high adhesion to the piezoelectric/electrostrictive body 5. Also, diffusion of foreign elements, which often occurs in use of glass, can be prevented. In addition, this material is reactive with and, accordingly, tightly joins to the ceramic substrate 1 because of high KNbO₃ content. Furthermore, (1-x) (Bi_{0.5}Na_{0.5})TiO₃-xKNbO₃ (0.08 ≤ x ≤ 0.5 in terms of molar fraction) hardly exhibits piezoelectric/electrostrictive characteristics and generates displacement in response to the electric field generated between the lower electrode 4 and the auxiliary electrode 8 in use, consequently helping the resulting sensor to exhibit stable properties.

The electrodes (upper electrode 6, lower electrode 4, auxiliary electrode 8) may be made of gold, platinum, palladium, rhodium, iridium, silver, or their alloy.

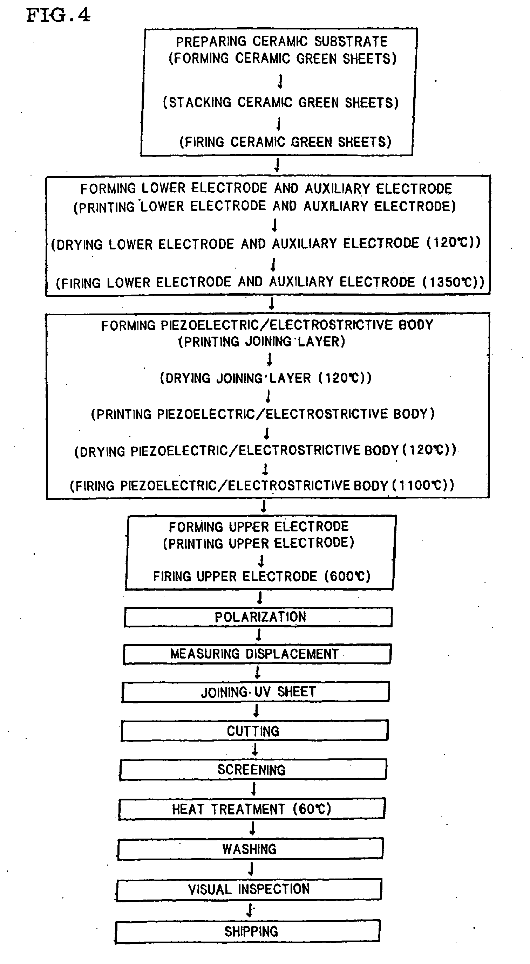

The method for manufacturing a piezoelectric/electrostrictive device of the present invention will now be described with reference to an embodiment using the piezoelectric/electrostrictive device 20. Fig. 4 shows a process for manufacturing the piezoelectric/electrostrictive device 20.

### Step 1: Preparing the ceramic substrate

The ceramic substrate 1 may be formed by stacking green sheets. More specifically, a predetermined number of ceramic green sheets mainly containing the above-mentioned ceramic material are prepared. A required number of sheets of the prepared ceramic green sheets are punched with a punching machine including a punch and a die to form holes in a predetermined shape defining the cavity 10 after stacking. A required number of other ceramic green sheets are punched to form holes in a predetermined shape defining the through-holes 9 after stacking. The rest of the ceramic green sheets, which are intended to define the thin diaphragm portion 3, the ceramic green sheets having holes intended for the cavity 10, and the ceramic green sheets having holes intended for the through-holes 9 are stacked, in this order, one on top of another to form a green stack. The green stack is fired to yield the ceramic substrate 1. Each ceramic green sheet has a thickness of, for example, about 100 to 300 µm, except for the ceramic green sheets intended to define the thin diaphragm portion 3.

The ceramic green sheets may be formed by a known manufacturing process of ceramic. For example, powder of a desired ceramic material is blended with a binder, a solvent, a dispersant, a plasticizer, and the like to prepare a slurry having a desired composition. After defoaming, the slurry is formed into sheets by, for example, a doctor blade method, a reverse roll coating method, or a reverse doctor roll coating method, and thus the ceramic green sheets are prepared.

### Step 2: Forming the lower electrode and the auxiliary electrode

The lower film electrode 4 and auxiliary electrode 8 are formed on the external surface of the thin diaphragm portion 3 of the ceramic substrate 1 by any of a variety of film forming methods, followed by drying and firing. For example, the lower electrode 4 and auxiliary electrode are formed by a method appropriately selected from among thin-film forming methods, such as ion beam, sputtering, vapor deposition, CVD, ion plating, and plating, and thick film forming methods, such as screen printing, spraying, and dip coating. Among these methods preferred are sputtering and screen printing. The drying is performed at a temperature of 50 to 150°C, and the firing is performed at a temperature of 500 to 900°C.

For providing the incompletely joined regions 7A and 7B, the materials of the piezoelectric/electrostrictive body 5 and the ceramic substrate 1 are selected so that they have low reactivity to each other. In addition, a dummy layer may be formed before forming the piezoelectric/electrostrictive body 5 so that the piezoelectric/electrostrictive body 5 is not directly brought into contact with the ceramic substrate 1. The dummy layer is formed by stamping, screen printing, or an ink jet method at the same timing with the formation of the lower electrode 4. If the piezoelectric/electrostrictive body 5 is fired (heated to sinter) in a subsequent step, the dummy layer is made of a material that can be burned or lost by firing, such as a resin. Thus, the incompletely joined regions 7A and 7B are provided by disappearance of the dummy layer. If the piezoelectric/electrostrictive body 5 and the upper electrode 6 are not fired, the dummy layer can be made of a resin soluble in a solvent, such as water or an organic solvent. The dummy layer is dissolved to remove with the solvent after forming the piezoelectric/electrostrictive body 5 or after forming the piezoelectric/electrostrictive body 5 and the upper electrode 6, and thus the incompletely joined regions 7A and 7B are provided.

The joining layer, if provided, is formed by a thick film forming method, particularly by stamping or screen printing. If the joining layer has a size of several tens of micrometers to several hundreds of micrometers, it is preferably formed by an ink jet method. If the joining layer requires heat treatment, the joining layer may be heat-treated independently before forming the piezoelectric/electrostrictive body 5, or may be simultaneously heat-treated with the piezoelectric/electrostrictive body 5 after the formation of the piezoelectric/electrostrictive body 5.

### Step 3: Forming the piezoelectric/electrostrictive body

The piezoelectric/electrostrictive body 5 is formed by a known film forming method in the same manner as the lower electrode 4 and the auxiliary electrode 8, followed by firing (corresponding to step A1 of firing the piezoelectric/electrostrictive body). Preferably, screen printing is applied from the viewpoint of low cost. The resulting piezoelectric/electrostrictive body 5 is integrated with the previously formed lower electrode 4 and auxiliary electrode 8 and, if provided, the joining layer by firing. The firing is performed at a temperature of about 900 to 1,400°C for about 10 to 50 hours. It is preferred to fire the piezoelectric/electrostrictive body 5 so as not to make them unstable at a high temperature under control of atmosphere in the presence of the source from which the materials for the piezoelectric/electrostrictive elements.

### Step 4: Forming the upper electrode

The upper electrode 6 is formed in the same manner as the lower electrode 4 and the auxiliary electrode 8, followed by drying and firing. The upper electrode 6 is joined to the piezoelectric/electrostrictive body 5 and the auxiliary electrode 8 to be integrated into one body by firing.

The piezoelectric/electrostrictive element 12 is thus produced. The piezoelectric/electrostrictive element 12 may be formed independently and then joined onto the ceramic substrate 1, or directly formed on the ceramic substrate 1.

For joining the lower electrode 4, the joining layer (if provided), the piezoelectric/electrostrictive body 5, and the upper electrode 6 together by firing (heat treatment), these layers may be fired (heat-treated) separately after their respective formations, or may be formed one after another and then fired (heat-treated) together. It goes without saying that the firing (heat treatment) temperature is appropriately set so as to achieve high adhesion and prevent deterioration resulting from the diffusion of constituent elements of the layers.

Thus, a structure intended for the piezoelectric/electrostrictive device 20 including the ceramic substrate 1 and the piezoelectric/electrostrictive element 12 is completed through the above-described steps.

### Step 5: Polarization

A voltage of, for example, 300 VDC is applied between the upper electrode 6 and the lower electrode 4 of the piezoelectric/electrostrictive element 12 for polarization.

### Step 6: Measuring displacement

An alternating sinusoidal voltage of 0 to 200 V and 1 kHz is applied to the device and the displacement of the polarized piezoelectric/electrostrictive element 12 is measured with, for example, a laser Doppler vibrometer.

### Step 7: Joining UV sheet

A UV sheet is joined as fixing means onto the surface of the piezoelectric/electrostrictive device 20 opposite the piezoelectric/electrostrictive element 12, and the piezoelectric/electrostrictive device 20 is fixed to a predetermined place.

### Step 8: Cutting

While all the proceedings are carried out without cutting until the previous step even in the case that a plural number of the devices is taken by cutting, an individual device is produced by cutting the device 20 using, for example, a dicer at this stage.

### Step 9: Screening

For screening, devices exhibiting a displacement of a specified value or more in Step 6 are left out as defectives.

### Step 10: Heat treatment

The conforming devices are subjected to heat treatment at a temperature in the range of 60 to 900°C. This step thermally expands the device to activate an excess of the alkali metal or alkaline-earth metal in the piezoelectric/electrostrictive body 5. If the heat treatment temperature is lower than 60°C, low thermal expansion may result and, accordingly, the productivity may be reduced. Depending on the properties of the material of the piezoelectric/electrostrictive body 5, the heat treatment temperature can be appropriately selected from the range of temperatures at which the crystal structure of the material is not destroyed. In particular, temperatures over the neighborhood of the transition point of the piezoelectric/electrostrictive body 5 are preferred. For example, if a piezoelectric/electrostrictive material mainly containing (Bi_{0.5}Na_{0.5})TiO₃ (bismuth sodium titanate) is used, the heat treatment temperature is preferably 320°C or more. More preferably, the temperature is set between the melting point and the boiling point of the alkali metal or alkaline-earth metal. For example, if the alkali metal or alkaline-earth metal is sodium, the temperature is preferably 830°C or less.

### Step 11: Washing (corresponding to step B2 of washing)

The entire structure defining the piezoelectric/electrostrictive device 20 (at least the piezoelectric/electrostrictive element 12) is washed with an acidic solution or pure water. This washing step removes the alkali metal or alkaline-earth metal and the compounds containing them, or constituents of the electrodes and the compounds containing them present on the surface of the piezoelectric/electrostrictive body 5, thereby improving the electrical characteristics on its surface. In addition, by removing the alkali metal or alkaline-earth metal or the compounds containing them, the residual stress in the crystal is reduced, so that the crystal can exhibit the inherent characteristics. The washing step may be performed by immersing the device in an acidic solution or pure water, or by flushing the device with the acidic solution or pure water. Preferably, the washing step is performed by spraying the surface of the piezoelectric/electrostrictive body with a mist of the acidic solution or pure water, then drying the surface at a temperature of about 40 to 60°C, and performing air-blowing.

### Step 12: Visual inspection

Finally, the appearance of the piezoelectric/electrostrictive device 20 is checked and the product is shipped.

It can be confirmed that the alkali metal or alkaline-earth metal or the compounds containing them has been removed from the resulting piezoelectric/electrostrictive device 20 by measuring the amount of the alkali metal or alkaline-earth metal, compounds containing the alkali metal or alkaline-earth metal, or counterpart elements of the compounds on the surface with, for example, an X-ray photoelectron spectrometer or an X-ray microanalyser (EPMA, electron probe microanalyser) before and after washing.

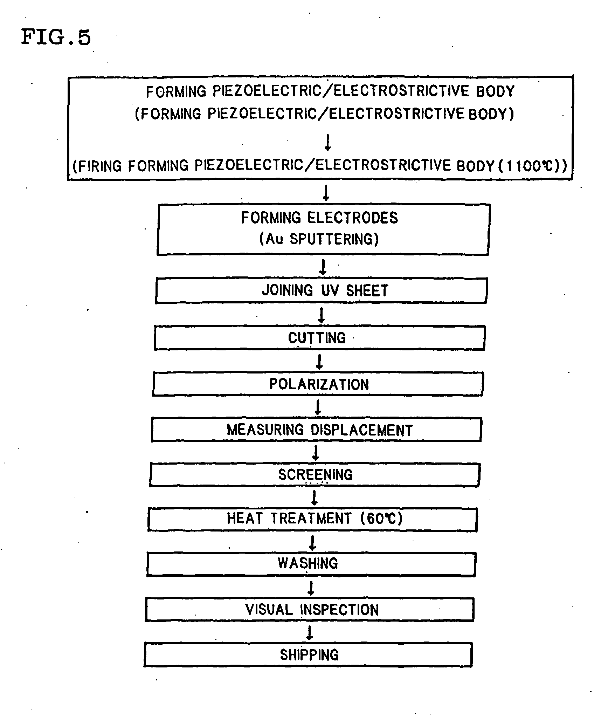

Fig. 5 shows a process of the method for manufacturing the piezoelectric/electrostrictive element according to an embodiment. Unlike the method for manufacturing the piezoelectric/electrostrictive device, step 1 is unnecessary in this process. The piezoelectric/electrostrictive element can be manufactured through steps according to steps 2 to 12, except that the piezoelectric/electrostrictive body can be formed not only by screen printing, but also by forming a tape, that the joining layer may not be formed, and that the auxiliary electrode is arbitrarily provided. The detailed description of the method for manufacturing the piezoelectric/electrostrictive element is therefore omitted. In Fig. 5, the firing (heat treatment) condition is an example. Step A1 is performed in the process of forming the piezoelectric/electrostrictive body, and the washing step corresponds to Step B1.

### EXAMPLE

### EXAMPLE 1: Applying the step of washing

A sample of a piezoelectric/electrostrictive device having the same structure as the piezoelectric/electrostrictive device 20 (using the joining layer) was produced in the following process. First, a slurry was prepared by blending a binder, a solvent, a dispersant, and a plasticizer with powder of stabilized zirconium oxide. After defoaming, the slurry was formed into a plurality of ceramic green sheets by a doctor blade method. Holes were appropriately formed in a required number of ceramic green sheets. The ceramic green sheets intended to define a thin diaphragm portion, the ceramic green sheets having holes intended for a cavity, and the ceramic green sheets having holes intended for through-holes were stacked in that order. The stacked layers were compressed to yield a green stack. Then, the green stack was fired at 1500°C to yield a ceramic substrate.

Then, a slurry mainly containing an electrode material was applied onto the thin diaphragm portion of the resulting ceramic substrate by screen printing, and was subsequently fired at 1350°C to yield a lower electrode 4 and an auxiliary electrode 8. Then, a slurry mainly containing a joining layer material and a slurry mainly containing a piezoelectric/electrostrictive material are applied in that order by screen printing, and were fired at 1,100°C to yield a joining layer and a piezoelectric/electrostrictive body 5. Finally, a slurry mainly containing an upper electrode material was applied by screen printing and fired at 600°C to yield an upper electrode 6. A piezoelectric/electrostrictive element 12 including the lower electrode 4, the auxiliary electrode 8, the piezoelectric/electrostrictive body 5, and the upper electrode 6 was thus prepared, and an unpolarized piezoelectric/electrostrictive device was obtained.

The slurry for the lower electrode 4 contained a platinum-based alloy. The slurry for the joining layer mainly contained (1-x) (Bi_{0.5}Na_{0.5})TiO₃-xKNbO₃ (0.08 ≤ x ≤ 0.5 in terms of molar fraction). The slurry for the piezoelectric/electrostrictive body 5 contained a piezoelectric/electrostrictive material mainly composed of (Bi_{0.5}Na_{0.5})TiO₃ (bismuth sodium titanate). The slurry for the upper electrode 6 contained a gold-based alloy. The slurry for the auxiliary electrode 8 contained a silver-based alloy.

A voltage of 120 V was applied between the electrodes to polarize the sample. Then, the sample was washed with pure water with a specific resistance of 1 MΩ·cm.

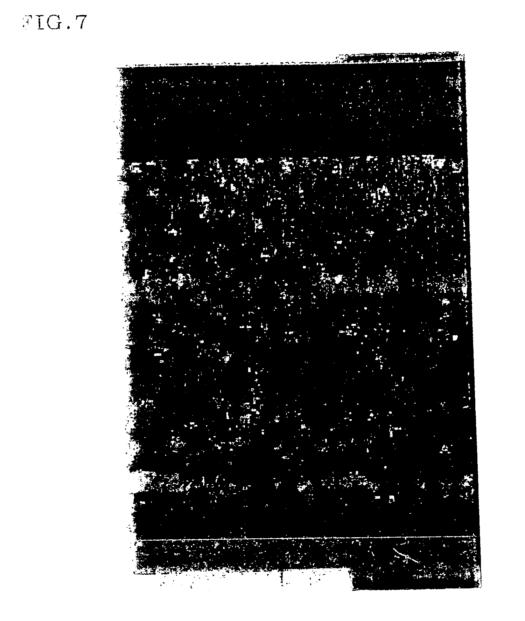

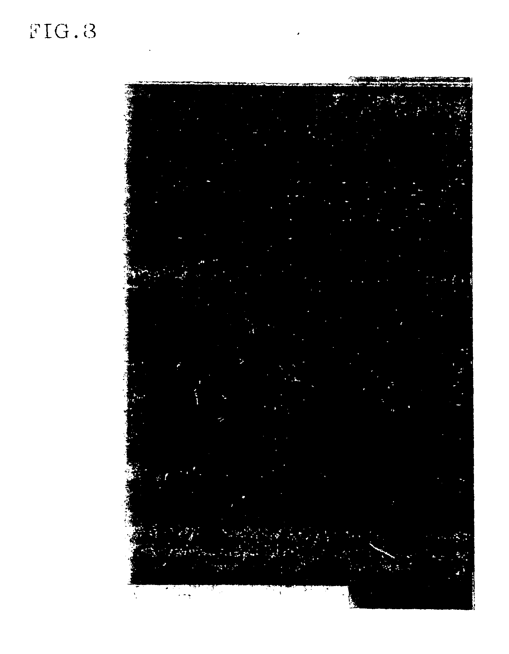

The sample of the piezoelectric/electrostrictive device was subjected to measurement for the amount of sulfur at the surface before and after washing with an X-ray microanalyser (EPMA). Fig. 7 shows the surface of the piezoelectric/electrostrictive device before washing and Fig. 8 shows the surface of the piezoelectric/electrostrictive device after washing. The reason why sulfur was measured is that it was presumed that the alkali metal or alkaline-earth metal (sodium (Na) in the Example) was sulfurated to produce a sulfur compound.

### COMPARATIVE EXAMPLE: Not applying the step of washing

A sample of the piezoelectric/electrostrictive device was produced in the same manner as in Example except that the step of washing is not performed.

### Evaluation

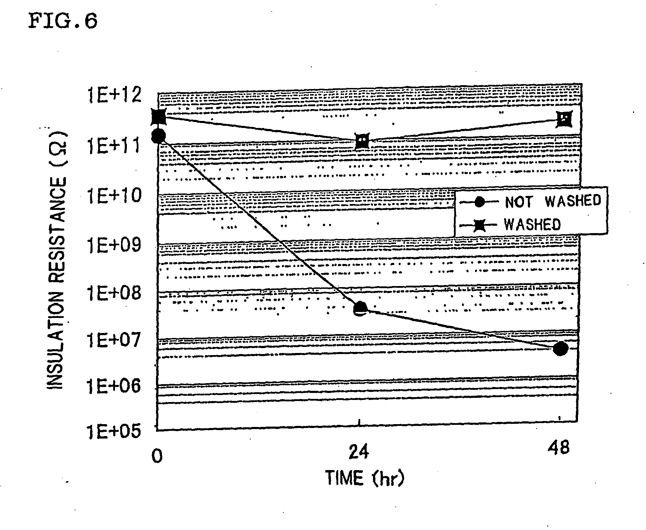

The samples of the Example and Comparative Example were allowed to stand under an environment of a humidity of 80% and a temperature of 25°C for two days, and the insulation resistance between the lower electrode and the upper electrode was measured on the first day, after one day (24 hours), and after two days (48 hours) with an insulation resistance tester (model R8340, manufactured by Advantest). The results were shown in Fig. 6.

### Results

Figs. 7 and 8 clearly show that sulfur at the surface of the piezoelectric/electrostrictive device was reduced after washing in comparison with that before washing. This suggests that sodium compounds combined with sulfur were probably removed as well. In the EPMA photographs of Figs. 7 and 8, the amount of measuring object is increased in the order of blue, green, yellow, vermilion, and red (blue indicates it is lowest and red indicates it is highest).

Fig. 6 shows that while the insulation resistance of the not washed piezoelectric/electrostrictive device was significantly reduced, the insulation resistance of the washed piezoelectric/electrostrictive device was not reduced. This suggests that the washed piezoelectric/electrostrictive device can exhibit a desired characteristic after applying a predetermined voltage to the piezoelectric/electrostrictive body. On the other hand, in case that piezoelectric/electrostrictive device is not washed, the effective voltage is probably reduced due to the reduced insulation resistance between the lower electrode and the upper electrode, even if the same source voltage is applied to the piezoelectric/electrostrictive body. Consequently, a desired characteristic cannot be exhibited.

The method for manufacturing the piezoelectric/electrostrictive element of the present invention can be suitably applied to the manufacture of sensor elements for sensing fluid properties or determining whether the object is liquid or gas, or sensing sound pressure, low weight, acceleration, or any other characteristic, and actuator elements. In particular, the method of the present invention can be suitably applied to the manufacture of piezoelectric/electrostrictive elements used under conditions of high humidity.

The piezoelectric/electrostrictive device produced by the method of the present invention may be washed after being mounted on a product on which the device is used, such as a printed circuit board. Thus, deposition produced by heating for mounting the device on, for example, a printed circuit board can be removed, and a thermally activated alkali metal or alkaline-earth metal present on the surface or the alkali metal or alkaline-earth metal remaining deposited thereon after heating can be removed. In addition, the piezoelectric/electrostrictive device produced by the method of the present invention and used in an environment where engines or personal computers are used, or heated for maintenance can recover its original properties by washing.

## Claims

1. A method for manufacturing a piezoelectric/electrostrictive element (12) having multilayer structure including a piezoelectric/electrostrictive body (5) containing (1-x) (Bi_{0.5}Na_{0.5})TiO₃-xKNbO₃, wherein 0≤x≤0.06 in terms of molar fraction, as a major component, and a pair of film electrodes (4, 6) with the piezoelectric/electrostrictive body (5) sandwiched therebetween, the method comprising:
step A1 of firing the piezoelectric/electrostrictive body (5) and the pair of electrode films (4, 6); and
step B1 of washing the piezoelectric/electrostrictive element (12) including the piezoelectric/electrostrictive body (5) with an acidic solution or pure water,
wherein the step B1 is performed at least once after the step A1.

2. The method according to claim 1, further comprising step C1 of heating the piezoelectric/electrostrictive body (5) after the step A1 and before the step B1.

3. The method according to claim 2, wherein the heating at the step C1 is performed at a temperature in the range of 60 to 900°C.

4. The method according to any one of claims 1 to 3, wherein the washing at the step B1 includes the sub steps of bringing the acidic solution or pure water into contact with the surface of the piezoelectric/electrostrictive body (5), drying the piezoelectric/electrostrictive body (5), and performing air blowing onto the piezoelectric/electrostrictive body (5).

5. The method according to any one of claims 1 to 4, wherein the acidic solution or pure water is used in the washing at the step B1 in form of mist.

6. The method according to any one of claims 1 to 5, wherein the washing at the step B1 removes a compound containing the alkali metal or alkaline-earth metal adhere on the surface of the piezoelectric/electrostrictive element therefrom.

7. The method according to claim 6, wherein the compound is at least one selected from the group consisting of hydroxides, carbonates, hydrogencarbonates, sulfates, and sulfides.

8. The method according to any one of claims 1 to 7, wherein the washing at the step B1 removes at least one of a sodium salt, a sulfate and a sulfide containing constituent of the film electrodes and adhered on the surface of the piezoelectric/electrostrictive element therefrom.

9. A method according to any one of claims 1 to 8, further including the step of manufacturing a piezoelectric/electrostrictive device (20) including: a ceramic substrate (1) having a thin diaphragm portion (3) and a thick portion (2) integrally formed around the thin diaphragm portion (3), the thin diaphragm portion (3) and the thick portion (2) defining a cavity (10) communicating with the outside of the structure, the piezoelectric/electrostrictive element (12) being disposed on the external surface of the thin diaphragm portion (3) of the ceramic substrate (1) so that the thin diaphragm portion (3) is vibratable in synchronization with the operation of the piezoelectric/electrostrictive element (12).

## Patentansprüche

1. Verfahren zur Herstellung eines piezoelektrischen/elektrostriktiven Elements (12) mit Mehrschichtstruktur, einschließlich eines piezoelektrischen/elektrostriktiven Körpers (5), der (1-x) (Bi_{0,5}Na_{0,5})TiO₃-xKNbO₃ als Hauptkomponente enthält, worin in Bezug auf den Molenbruch gilt 0 ≤ x ≤ 0,06, und eines Paares Filmelektroden (4, 6), wobei der piezoelektrische/elektrostriktive Körper (5) zwischen diesen angeordnet ist, wobei das Verfahren Folgendes umfasst:
Schritt A1 des Brennens des piezoelektrischen/elektrostriktiven Körpers (5) und des Elektrodenfilm-Paars (4, 6); und
Schritt B1 des Waschens des piezoelektrischen/elektrostriktiven Elements (12), einschließlich des piezoelektrischen/elektrostriktiven Körpers (5), mit einer sauren Lösung oder reinem Wasser,
wobei der Schritt B1 zumindest ein Mal nach Schritt A1 durchgeführt wird.

2. Verfahren nach Anspruch 1, das weiters Schritt C1 des Erhitzens des piezoelektrischen/elektrostriktiven Körpers (5) nach Schritt A1 und vor Schritt B1 umfasst.

3. Verfahren nach Anspruch 2, worin das Erhitzen in Schritt C1 auf eine Temperatur im Bereich von 60 bis 900°C erfolgt.

4. Verfahren nach einem der Ansprüche 1 bis 3, worin das Waschen in Schritt B1 die untergeordneten Schritte des In-Kontakt-Bringens der sauren Lösung oder des reinen Wassers mit der Oberfläche des piezoelektrischen/elektrostriktiven Körpers (5), des Trocknens des piezoelektrischen/elektrostriktiven Körpers (5) und des Durchführens des Aufblasens von Luft auf den piezoelektrischen/elektrostriktiven Körper (5) umfasst.

5. Verfahren nach einem der Ansprüche 1 bis 4, worin die saure Lösung oder das reine Wasser beim Waschen in Schritt B1 in Form eines Nebels verwendet wird.

6. Verfahren nach einem der Ansprüche 1 bis 5, worin das Waschen in Schritt B1 eine Verbindung, die ein Alkalimetall oder Erdalkalimetall enthält und an der Oberfläche des piezoelektrischen/elektrostriktiven Elements haftet, von diesem entfernt.

7. Verfahren nach Anspruch 6, worin die Verbindung zumindest eine aus der aus Hydroxiden, Carbonaten, Hydrogencarbonaten, Sulfaten und Sulfiden bestehenden Gruppe ausgewählte Verbindung ist.

8. Verfahren nach einem der Ansprüche 1 bis 7, worin das Waschen in Schritt B1 zumindest eine von einer ein Natriumsalz, ein Sulfat und ein Sulfid enthaltenden Komponente der Filmelektroden, die an der Oberfläche des piezoelektrischen/elektrostriktiven Elements haftet, von diesem entfernt.

9. Verfahren nach einem der Ansprüche 1 bis 8, das ferner den Schritt des Herstellens einer piezoelektrischen/elektrostriktiven Vorrichtung (20) umfasst, die Folgendes umfasst: ein Keramiksubstrat (1) mit einem dünnen Membranabschnitt (3) und einem dicken Abschnitt (2), der einstückig um den dünnen Membranabschnitt (3) herum ausgebildet ist, wobei der dünne Membranabschnitt (3) und der dicke Abschnitt (2) einen Hohlraum (10) definieren, der mit der Außenseite der Struktur kommuniziert, wobei das piezoelektrische/elektrostriktive Element (12) auf der Außenoberfläche des dünnen Membranabschnitts (3) des Keramiksubstrats (1) so angeordnet ist, dass der dünne Membranabschnitt (3) synchron mit der Betätigung des piezoelektrischen/elektrostriktiven Elements (12) in Schwingung versetzt werden kann.

## Revendications

1. Procédé de fabrication d'un élément piézoélectrique/électrostrictif (12) ayant une structure multicouche incluant un corps piézoélectrique/électrostrictif (5) contenant (1-x) (Bi_{0,5}Na_{0,5})TiO₃-xKNbO₃, où 0≤x≤0,06 en termes de fraction molaire, comme composant majeur, et une paire d'électrodes de film (4, 6) avec le corps piézoélectrique/électrostrictif (5) pris en sandwich entre celles-ci, le procédé comprenant:
étape A1 de cuisson du corps piézoélectrique/électrostrictif (5) et de la paire de films d'électrode (4, 6); et
étape B1 de lavage de l'élément piézoélectrique/électrostrictif (12) incluant le corps piézoélectrique/électrostrictif (5) avec une solution acide ou avec de l'eau pure,
où l'étape B1 est exécutée au moins une fois après l'étape A1.

2. Procédé selon la revendication 1, comprenant en outre l'étape C1 de chauffage du corps piézoélectrique/électrostrictif (5) après l'étape A1 et avant l'étape B1.

3. Procédé selon la revendication 2, dans lequel le chauffage à l'étape C1 est exécuté à une température dans la plage de 60 à 900°C.

4. Procédé selon l'une quelconque des revendications 1 à 3, dans lequel le lavage à l'étape B1 comprend les sous-étapes consistant à amener la solution acide ou l'eau pure en contact avec la surface du corps piézoélectrique/électrostrictif (5), à sécher le corps piézoélectrique/électrostrictif (5) et à procéder à un soufflage d'air sur le corps piézoélectrique/électrostrictif (5).

5. Procédé selon l'une quelconque des revendications 1 à 4, dans lequel la solution acide ou l'eau pure est utilisée pour le lavage à l'étape B1 sous la forme de brume.

6. Procédé selon l'une quelconque des revendications 1 à 5, dans lequel le lavage à l'étape B1 retire un composé contenant le métal alcalin ou le métal alcalino-terreux adhérant à la surface de l'élément piézoélectrique/électrostrictif de celle-ci.

7. Procédé selon la revendication 6, dans lequel le composé est au moins un sélectionné dans le groupe consistant en hydroxydes, carbonates, carbonates d'hydrogène, sulfates et sulfides.

8. Procédé selon l'une quelconque des revendications 1 à 7, dans lequel le lavage à l'étape B1 retire au moins un d'un sel de sodium, d'un constituant contenant un sulfate et un sulfide des électrodes de film et adhérant à la surface de l'élément piézoélectrique/électrostrictif de celle-ci.

9. Procédé selon l'une quelconque des revendications 1 à 8, comprenant en outre l'étape consistant à fabriquer un dispositif piézoélectrique/électrostrictif (20) comportant: un substrat céramique (1) ayant une portion de membrane mince (3) et une portion épaisse (2) réalisée intégralement autour de la portion de membrane mince (3), la portion de membrane mince (3) et la portion épaisse (2) définissant une cavité (10) communiquant avec l'extérieur de la structure, l'élément piézoélectrique/électrostrictif (12) étant disposé sur la surface externe de la portion de membrane mince (3) du substrat céramique (1) de sorte que la portion de membrane mince (3) peut être amenée à vibrer en synchronisation avec l'opération de l'élément piézoélectrique/électrostrictif (12).
